# DEMANDE DE BREVET EUROPEEN

(11) **EP 0 890 992 A1**
(43) Date de publication de la demande: **13.01.1999**
(21) Numéro de dépôt: 98401704.6
(22) Date de dépôt: 06.07.1998
(51) Int. Cl.: H01L 27/02

(54) **Piste d'interconnexion reliant, sur plusieurs niveaux de métallisation, une grille isolée d'un transistor à une diode de décharge au sein d'un circuit intégré, et procédé de réalisation d'une telle piste**

(30) Priorité: 10.07.1997 FR 9708807
(71) Demandeur: STMicroelectronics SA, 94250 Gentilly Cedex (FR)
(72) Inventeur: Borel, Joseph, 38120 Saint-Egrève (FR)
(74) Mandataire: Casalonga, Axel

(57) **Abrégé**

La piste d'interconnexion (PCN) comprend un premier élément de piste (EL1) s'étendant sous le niveau de métallisation le plus élevé, possédant une première extrémité reliée à ladite grille (GR) et ayant une longueur (L1) supérieure à une longueur critique prédéterminée. Ce premier élément de piste comporte une portion de piste interrompue (PP1) en un endroit (EMP) espacé de ladite première extrémité d'une première distance (L2) inférieure à ladite longueur critique et compatible avec le placement du niveau de métallisation supérieur, et s'étendant entre deux couches isolantes (IS1, IS2) sur un même niveau de métallisation (M1). Les deux branches (BP1, BP2) de ladite portion interrompue sont mutuellement reliées par un contact métallique de remplissage (CT1) s'étendant également dans la couche isolante de support (IS2) du niveau de métallisation (M2) immédiatement supérieur à celui (M1) contenant ladite portion de piste interrompue.

## Description

L'invention concerne la fabrication des circuits intégrés semiconducteurs et plus particulièrement la réalisation au sein d'un tel circuit intégré d'une piste d'interconnexion métallique reliant, sur plusieurs niveaux de métallisation, une grille isolée d'un transistor à une diode de décharge.

L'invention concerne également les circuits intégrés comportant de telles pistes d'interconnexion.

D'une façon générale, la réalisation des pistes d'interconnexion dans les circuits intégrés comporte, pour chaque niveau de métallisation, le dépôt d'une couche de métal sur une couche isolante épaisse, par exemple une couche de dioxyde de silicium de l'ordre de 6000 Å d'épaisseur, puis une gravure, généralement par plasma, de la couche de métal pour obtenir une piste ayant une largeur et une longueur prédéfinies.

L'homme du métier sait que lors de cette opération de gravure, des charges électriques se déposent sur les segments métalliques. Or, dans certains cas, un tel segment de métal peut être relié à la grille isolée d'un transistor à effet de champ à grille isolée (transistor MOSFET) et avoir son autre extrémité libre, c'est-à-dire non connectée à un autre composant. Une telle connexion est alors dite "flottante". Si la longueur de cette connexion flottante est trop importante, la quantité de charge déposée sur le segment métallique correspondant, proportionnelle à la longueur de ce dernier, va créer à travers l'oxyde de grille, qui est un oxyde mince, un courant de charge trop important qui va conduire à une dégradation plus ou moins rapide et plus ou moins brutale des performances du transistor.

On définit alors des règles particulières de conception de telles pistes d'interconnexion connues par l'homme du métier sous la dénomination "Règles d'antenne". Ces règles comportent la création de chemins de décharge pour les charges électriques accumulées sur les segments métalliques, en prévoyant par exemple de relier la grille d'un transistor MOSFET à une diode de décharge formée par exemple par la région de source ou par la région de drain d'un autre transistor MOS ou bien par une région spécifique réalisée dans le substrat semiconducteur. En outre, ces règles prévoient, en l'absence de diode de protection, la définition d'un rapport maximum entre la surface de métal d'une connexion flottante et la surface de la grille du transistor. En pratique, compte tenu que les largeurs des grilles et les largeurs des pistes sont identiques, on définit une longueur critique L_{C} que ne doit pas dépasser une connexion flottante. Cette longueur critique L_{C} est typiquement de l'ordre de 200 fois la longueur de la grille L_{G}.

Lorsqu'une piste d'interconnexion relie la grille d'un transistor MOS à une diode de décharge, sur un seul niveau de métallisation, le problème évoqué ci-dessus ne se pose pas puisque lors de l'opération de gravure de la piste d'interconnexion, la connexion n'est pas flottante, et les charges électriques sont évacuées dans la diode de décharge.

Le problème évoqué ci-dessus se pose pour une piste d'interconnexion reliant la grille d'un transistor MOS à une diode de décharge sur au moins deux niveaux de métallisation, avec un élément de piste s'étendant sous le niveau de métallisation le plus élevé et ayant une longueur supérieure à la longueur critique.

Lorsque le schéma de conception général du circuit intégré, c'est-à-dire le schéma de placement de tous les éléments du circuit intégré ainsi que la configuration géométrique de toutes les pistes d'interconnexion, a été défini, en général au moyen d'un outil de CAO, et qu'un tel schéma de conception général fait apparaître une piste d'interconnexion dont les caractéristiques géométriques sont en violation des règles d'antenne définies ci-dessus, une solution classique consiste à modifier la configuration géométrique initiale d'une telle piste d'interconnexion, par exemple en la faisant "monter" verticalement au sein du circuit intégré de façon à atteindre un niveau de métallisation plus élevé permettant la connexion directe à la diode de décharge.

Outre le fait qu'une telle solution nécessite des adaptations manuelles au cas par cas, elle conduit également à des circuits intégrés pouvant avoir une complexité de réalisation plus importante que celle prévue initialement et n'ayant pas la compacité maximale souhaitée.

Une autre solution pourrait consister à utiliser systématiquement des composants comportant un transistor MOSFET et une diode de décharge immédiatement voisine de ce transistor, de façon à ne pas violer les règles d'antenne ci-dessus définies. Cependant, une telle solution conduirait à une augmentation importante de la surface du circuit intégré.

L'invention vise à apporter une solution radicalement différente à ces problèmes.

L'invention a pour but de proposer un procédé de réalisation d'une piste d'interconnexion dont la configuration géométrique initiale révèle une violation des règles d'antenne, sans modifier fondamentalement cette configuration géométrique initiale et sans modifier le schéma de conception général du circuit intégré, c'est-à-dire sans modifier le placement des différents composants et/ou la configuration géométrique des interconnexions du circuit intégré.

Un but de l'invention est d'apporter une correction uniquement locale à la configuration géométrique initiale d'une telle piste d'interconnexion, correction locale dont la définition peut être effectuée de façon automatique grâce à un outil de CAO.

L'invention a également pour but de permettre l'utilisation dans une large mesure de transistors MOSFET standards, existant déjà dans des bibliothèques classiques de composants, et non équipés de diodes de protection (de décharge) adjacentes, ce qui permet d'obtenir des circuits intégrés plus denses et plus compacts avec une augmentation des performances en vitesse et une diminution de la puissance consommée.

L'invention propose donc un procédé de réalisation, au sein d'un circuit intégré, d'une piste d'interconnexion métallique reliant, sur plusieurs niveaux de métallisation, une grille isolée d'un transistor à une diode de décharge, procédé dans lequel on définit une configuration géométrique initiale de ladite piste, et on réalise chaque niveau de métallisation à partir de la formation d'une couche isolante de support et d'une gravure d'une couche de métal déposée sur cette couche isolante de support.

Selon une caractéristique générale de l'invention, lorsque ladite piste ainsi configurée comporte un premier élément de piste s'étendant sous le niveau de métallisation le plus élevé, cet élément de piste possédant une première extrémité reliée à la grille et ayant une longueur supérieure à une longueur critique prédéterminée, on sélectionne au sein du premier élément de piste, avantageusement par un outil de CAO, un emplacement espacé de ladite première extrémité d'une première distance inférieure à ladite longueur critique. Dans l'étape de réalisation du niveau de métallisation contenant cet emplacement sélectionné, on grave dans la couche de métal à l'endroit de cet emplacement sélectionné une zone exempte de métal de façon à réaliser une portion de piste interrompue. Puis, dans l'étape de réalisation du niveau de métallisation immédiatement supérieur, on ménage dans la couche isolante de support déposée sur ladite portion de piste interrompue, une cavité débouchant en regard de ladite zone, et on remplit ladite cavité ainsi que ladite zone par un métal de remplissage de façon à rétablir un contact métallique entre les deux branches de la portion de piste interrompue pour réaliser réaliser un élément de piste conforme à sa configuration géométrique initiale, et ceci sans contrainte de placement a priori.

En d'autres termes, selon l'invention, on définit le schéma de conception général du circuit intégré sans aucune contrainte relative aux règles d'antenne puis, lorsqu'une piste d'interconnexion est susceptible de violer lesdites règles, on sectionne cette piste à une distance inférieure à la longueur critique de façon que, lors de la gravure de ladite piste, la longueur de métal effectivement gravée, en contact avec le plasma et avec la grille du transistor, soit inférieure à cette longueur critique. Puis, lors de la réalisation du niveau de métallisation immédiatement supérieur, on court-circuite les deux branches de la piste ainsi interrompues en remplissant un via ménagé dans la couche isolante de support du niveau de métallisation supérieur, par un métal de remplissage classique, par exemple du tungstène.

Bien entendu, le sectionnement de la piste se fait à un endroit compatible avec le schéma de conception général du circuit intégré, c'est-à-dire en particulier à un endroit où il est possible de réaliser un via dans la couche isolante à la verticale du sectionnement, et de remplir ce via par un métal de remplissage sans que celui-ci ne vienne en contact avec d'autres pistes situées sur le niveau de métallisation supérieur.

On ménage avantageusement, dans ladite couche isolante de support du niveau de métallisation supérieur, une cavité ayant une taille plus importante que celle de ladite zone de la portion de piste interrompue. Ainsi, en pratique, pour une filière 0,5 micron, on ménagera une cavité ayant une longueur de l'ordre de 1,2 micron pour un espace entre les deux branches de la portion de piste interrompue de l'ordre de 0,8 micron. Le métal de remplissage viendra alors partiellement recouvrir les branches des portions de piste interrompues, ce qui favorisera une bonne connexion électrique entre ces deux branches.

Selon un mode de mise en oeuvre du procédé selon l'invention, dans l'étape de remplissage de la cavité, on dépose sur la couche isolante de support située sur ladite portion de piste interrompue, ainsi que dans ladite cavité et dans ladite zone d'interruption de piste, du métal de remplissage, puis on effectue un polissage mécanochimique de la couche de métal de remplissage déposée sur la couche isolante de support. En d'autres termes, on remplit le via ménagé dans la couche isolante ainsi que ladite zone d'interruption de piste, puis on effectue un polissage mécanochimique de façon à retirer le surplus de métal de remplissage déposé sur la surface supérieure de la couche isolante. En outre, le polissage mécanochimique présente l'avantage de ne pas induire de charges électriques supplémentaires au niveau de la grille du transistor.

Bien entendu, ces différentes étapes peuvent être répétées le cas échéant à chaque niveau de métallisation si les éléments de piste correspondants sont des connexions flottantes et ont des longueurs supérieures à la longueur critique.

Ainsi, selon un mode de mise en oeuvre du procédé selon l'invention, lorsque le premier élément de piste comporte plusieurs parties s'étendant sur plusieurs niveaux de métallisation distincts situés sous le niveau de métallisation le plus élevé, on peut réaliser sur une première partie un premier contact métallique de remplissage espacé de la grille de ladite première distance, et on peut réaliser sur au moins une deuxième partie un deuxième contact métallique de remplissage analogue au premier et espacé de l'extrémité de cette deuxième partie reliée à la première partie d'une deuxième distance, chacune des première et deuxième distances étant inférieure à la longueur critique.

L'invention a également pour objet un circuit intégré comportant une telle piste d'interconnexion métallique, et a plus particulièrement pour objet une piste d'interconnexion métallique reliant sur plusieurs niveaux de métallisation, au sein d'un circuit intégré, une grille isolée d'un transistor à une diode de décharge.

Selon une caractéristique générale de l'invention, cette piste d'interconnexion métallique comprend un premier élément de piste s'étendant sous le niveau de métallisation le plus élevé, possédant une première extrémité reliée à ladite grille et ayant une longueur supérieure à une longueur critique prédéterminée. Ce premier élément de piste comporte une portion de piste interrompue en un endroit espacé de ladite première extrémité d'une première distance inférieure à ladite longueur critique, et s'étend entre deux couches isolantes sur un même niveau de métallisation. Les deux branches de ladite portion interrompue sont mutuellement reliées par un contact métallique de remplissage s'étendant également dans la couche isolante de support du niveau de métallisation immédiatement supérieur à celui contenant ladite portion de piste interrompue.

Selon un mode de réalisation de l'invention, la partie du contact métallique située entre les extrémités des deux branches de la portion de piste interrompue, a une surface plus faible que celle de la partie supérieure du contact métallique s'étendant dans ladite couche isolante supérieure, cette partie supérieure s'appuyant partiellement sur les deux branches de la portion de piste interrompue.

La résistance électrique du contact métallique est de l'ordre de celle d'un via classique. En d'autres termes, elle est faible, typiquement de l'ordre d'une fraction d'ohm, typiquement 0,5 ohm.

Lors de l'opération de gravure de la cavité dans la couche isolante supérieure, il se produit également une légère gravure dans la couche isolante inférieure en-dessous de la zone exempte de métal. Ainsi, le contact métallique comporte une partie inférieure s'étendant avec un profil bombé dans la couche isolante inférieure. Un tel profil va également dans le sens de l'obtention d'un bon contact électrique entre les deux branches de la portion de piste interrompue.

Ceci étant, dans le cas où l'on souhaite que le contact métallique de remplissage ne déborde pas dans la couche inférieure isolante, on peut prévoir de déposer sur la couche isolante inférieure une couche d'un autre isolant qui ne sera pas attaquée lors de la gravure de la cavité. En pratique, si les couches isolantes sont réalisées en dioxyde de silicium (SiO₂), on peut prévoir d'utiliser pour cet autre matériau isolant, du nitrure de silicium (Si₃N₄).

D'autres avantages et caractéristiques de l'invention apparaîtront à l'examen de la description détaillée de modes de mise en oeuvre et de réalisation nullement limitatifs, et des dessins annexés, sur lesquels :
la figure 1 représente schématiquement la configuration géométrique initiale d'une piste d'interconnexion reliant la grille d'un transistor MOS à une diode de décharge,
les figures 2 à 5 illustrent schématiquement les principales étapes d'un mode de mise en oeuvre du procédé selon l'invention, permettant la réalisation matérielle de la piste d'interconnexion de la figure 1,
la figure 6 illustre plus en détail la forme d'un contact métallique de remplissage au niveau de l'interruption d'une piste, et
les figures 7 et 8 d'une part, et 9 et 10 d'autre part, illustrent respectivement schématiquement deux autres pistes d'interconnexion selon l'invention, et leur réalisation matérielle.

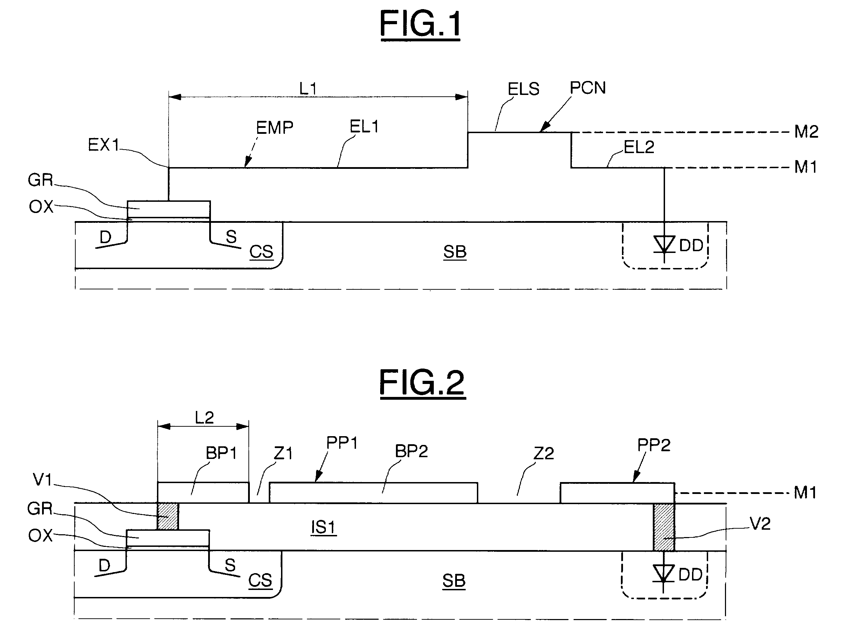

Sur les figures 1 à 5, la référence SB désigne un substrat semiconducteur, par exemple en silicium, au sein duquel a été réalisé un caisson CS destiné à recevoir les zones actives d'un transistor à effet de champ à grille isolée, dont on a représenté ici très schématiquement à des fins de simplification uniquement les zones de drain D et de source S. La grille de ce transistor (transistor MOSFET) encaissonnée dans le caisson CS, est isolée du substrat par une mince couche d'oxyde OX.

Dans ce substrat est également ménagée une région DD formant une diode de décharge. Cette région DD peut être par exemple la région de source ou de drain d'un autre transistor à effet de champ.

Le schéma de conception général du circuit intégré, c'est-à-dire le schéma de placement global de tous les composants et de toutes les pistes d'interconnexion du circuit intégré au sein duquel se situent ce transistor et la diode de décharge DD, prévoit l'interconnexion de la grille GR du transistor et de la région DD par une piste d'interconnexion PCN s'étendant sur deux niveaux de métallisation M1 et M2. On suppose en effet, comme illustré sur la figure 1, qu'il n'a pas été possible de relier la grille du transistor à la diode de décharge DD au moyen d'une piste d'interconnexion s'étendant sur un seul niveau de métallisation, en raison par exemple de la présence d'une autre piste d'interconnexion s'étendant transversalement à la piste PCN. A des fins de simplifications, cette autre piste n'a pas été représentée sur les figures 1 à 5.

La piste PCN comporte un premier élément de piste EL1 et un deuxième élément de piste EL2 s'étendant au premier niveau de métallisation M1. Une première extrémité EX1 de l'élément de piste EL1 est reliée par l'intermédiaire d'un trou d'interconnexion, ou "via", à la grille GR du transistor, tandis que la deuxième extrémité de l'élément de piste EL2 est reliée par l'intermédiaire d'un via à la région de diode DD.

La deuxième extrémité de l'élément de piste EL1 et la première extrémité de l'élément de piste EL2 sont respectivement reliées par deux vias à un élément de piste ELS de niveau de métallisation supérieur M2, qui est ici le niveau de métallisation le plus élevé.

Si la piste PCN s'était étendue sur un seul niveau de métallisation, il n'y aurait eu aucun risque de dégradation de l'oxyde de grille car, lors de l'opération de gravure de la piste métallique, les charges électriques se seraient évacuées dans la diode de décharge.

Cependant, en l'espèce, la longueur L1 du premier élément de piste EL1 est supérieure à la longueur critique. A titre indicatif, pour des longueurs de grille de 0,5 micron, la longueur critique LC à ne pas dépasser pour une connexion flottante est de l'ordre de 100 microns.

Pour satisfaire aux obligations des règles d'antenne et afin de ne pas modifier la configuration géométrique initiale de la piste PCN, et plus généralement la configuration initiale du schéma de conception ou de placement global du circuit intégré, l'invention propose un procédé dont un exemple de mise en oeuvre va être décrit plus en détail en se référant plus particulièrement aux figures 2 à 6.

On va maintenant décrire, en se référant à la figure 2, la gravure proprement dite des portions de piste PP1 et PP2 correspondant respectivement aux éléments de piste EL1 et EL2. A cet égard, une couche de métal, par exemple de l'aluminium, est déposée sur une couche isolante de support inférieur IS1 dans laquelle on a au préalable réalisé des vias V1 et V2, remplis d'un métal de remplissage, par exemple du tungstène, et permettant de connecter la grille du transistor et la région de diode DD. On ne décrit pas ici, à des fins de simplification, les étapes de réalisation de la couche IS1 et de ses vias, qui sont parfaitement connues de l'homme du métier. De même dans la suite on ne décrira pas à des fins de simplification la réalisation classique des couches de barrière de diffusion (par exemple en TiN) disposées entre des niveaux de métallisation en aluminium et des vias en tungstène.

Au niveau de la définition du schéma de conception général du circuit intégré, et plus particulièrement de la configuration géométrique initiale de la piste PCN, on sélectionne au sein du premier élément de piste EL1, par exemple directement par l'outil de CAO ayant permis l'établissement du schéma général de conception de circuit intégré, un emplacement EMP situé à un endroit compatible avec le schéma général de conception du circuit intégré (plus particulièrement la couche M2) et en outre situé à une distance L2 de la grille GR, inférieure à la longueur critique, et de préférence le plus près possible de la grille du transistor. On reviendra plus en détail ci-après sur cette notion de compatibilité avec le schéma de conception général du circuit intégré.

A l'aide d'un masque de gravure approprié, on grave en largeur et en longueur la couche de métal déposée sur la couche isolante IS1 de façon à matérialiser la portion de piste PP1 et la portion de piste PP2. A cet égard, après la gravure, la portion de piste PP1 est interrompue au niveau de l'emplacement sélectionné et se compose donc de deux branches BP1 et BP2 séparées par une zone Z1 exempte de métal. De même, la portion de piste PP1 et la portion de piste PP2 sont séparées par une zone Z2 exempte de métal.

Ainsi, compte tenu du fait que la longueur de connexion flottante L2 effectivement reliée à la grille GR, est inférieure à la longueur critique, les règles d'antenne ont été respectées.

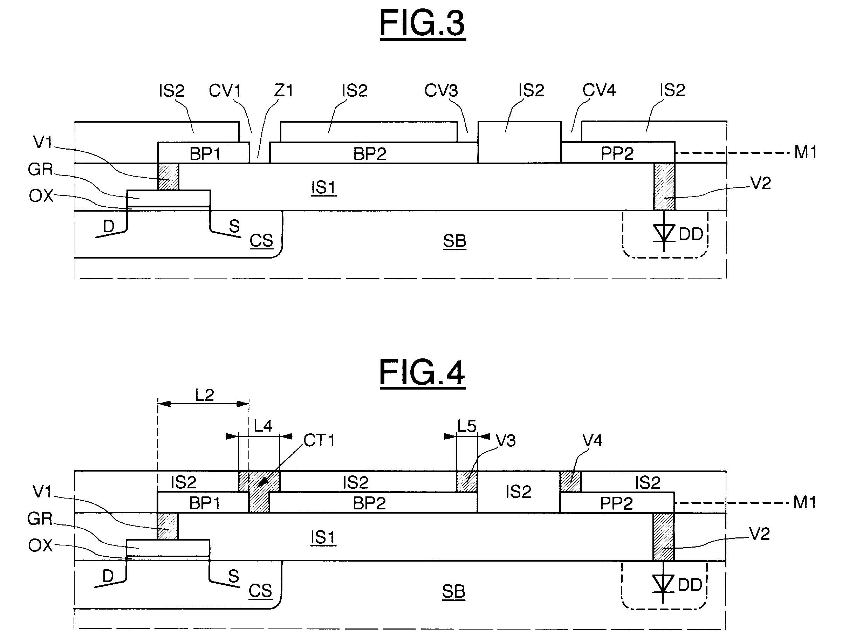

Dans l'étape suivante (figure 3) après avoir déposé de façon classique une couche isolante supérieure IS2 sur le niveau de métallisation M1, on pratique dans cette couche isolante IS2 une cavité CV1 située à la verticale de la zone Z1 et débouchant dans cette dernière. On pratique de même des cavités CV3 et CV4 qui seront destinées à former des vias de connexion avec le niveau de métallisation supérieur.

On dépose ensuite sur l'ensemble ainsi formé une couche d'un métal de remplissage (tungstène par exemple) qui remplit la cavité CV1, la zone Z1, ainsi que les cavités CV3 et CV4. On procède alors à un polissage mécanochimique de cette couche de métal de façon à faire araser le métal de remplissage situé dans les différentes cavités au niveau de la couche isolante IS2 et à supprimer tout métal de remplissage entre ces différentes cavités (figure 4).

L'homme du métier remarque donc que, par cette opération, on a à la fois réalisé les vias V3 et V4 de connexion au niveau des métallisations supérieures M2, mais on a en outre réalisé un contact métallique de remplissage CT1 permettant de rétablir le contact électrique entre les deux branches BP1 et BP2 de la portion de piste PP1 interrompue.

Ainsi, l'invention est remarquable en ce sens que grâce à une correction locale de l'élément de piste EL1 définie par CAO, on obtient finalement sans contrainte de surface une portion de piste PP1 correspondante conforme à la configuration géométrique initiale de l'élément de piste EL1, et ce tout en ayant respecté les règles d'antenne.

Lors de ce polissage mécanochimique, les longueurs de connexion L4 et L5 du contact métallique de remplissage CT1 et du via V3 font de fait partie de la connexion flottante reliée à la grille GR. Aussi, en théorie, en particulier si l'étape de réalisation du contact de remplissage et des vias était susceptible d'engendrer des charges électriques, il conviendrait que la somme des longueurs L2, L4 et L5 soit inférieure à la longueur critique. Ceci étant, en pratique, on ne s'intéressera essentiellement qu'à la valeur de la longueur L2. En effet, les longueurs L4 et L5 sont extrêmement faibles par rapport aux longueurs critiques habituellement définies, par exemple de l'ordre de 1 micron. En outre, le polissage mécanochimique n'apporte quasiment pas de charge électrique supplémentaire.

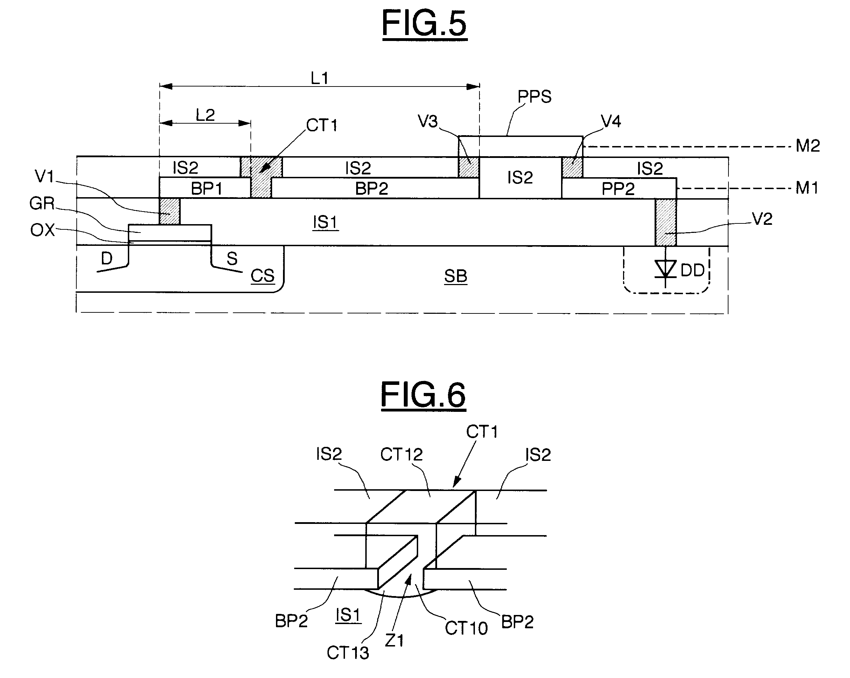

Lors de l'étape suivante (figure 5), on dépose sur la couche isolante de support supérieur IS2 une autre couche de métal puis l'on grave la portion de piste PPS de niveau le plus élevé correspondant au niveau de métallisation M2. Lors de cette opération de gravure, les problèmes de charge électrique évoqués ci-avant ne se posent pas puisque la grille GR du transistor est alors reliée à la diode de décharge DD.

On remarque que la compatibilité de l'emplacement sélectionné de sectionnement de l'élément de piste impose ici en particulier que la surface supérieure du contact de remplissage CT1 ne vienne pas en contact avec une autre piste d'interconnexion de façon à ne pas créer des interconnexions non conformes au schéma électrique général du circuit intégré.

En pratique, on sélectionnera donc un emplacement de sectionnement à la verticale duquel la zone isolante de support du niveau de métallisation immédiatement supérieur ne supporte pas de piste métallique et respectant les règles évoquées plus haut.

Sur la figure 6, on voit que le contact métallique de remplissage CT comporte une partie supérieure CT12 qui s'étend dans la couche isolante supérieure IS2 et qui repose partiellement sur les extrémités des deux branches BP1 et BP2 de la portion de piste interrompue PP1. Ceci favorise un bon contact électrique entre ces deux branches. Par ailleurs, lors de l'opération de gravure de la cavité CV1 de la couche isolante IS2, il s'est produit dans la couche isolante inférieure IS1, qui est du même matériau que celui de la couche IS2 (dioxyde de silicium par exemple), une dépression. En conséquence, le contact métallique CT1 comporte, sous la partie CT10 située entre les deux branches BP1 et BP2, une partie inférieure bombée CT13 qui empiète également partiellement sur les extrémités des deux branches BP1 et BP2, favorisant là encore un bon contact électrique.

Ceci étant, dans le cas où l'on ne souhaite pas obtenir une telle partie bombée inférieure, on peut éventuellement déposer sur la couche isolante IS1 de dioxyde de silicium, une couche de nitrure de silicium Si₃N₄ qui ne sera pas attaquée lors de l'opération de gravure de la couche isolante supérieure IS2 formée de dioxyde de silicium.

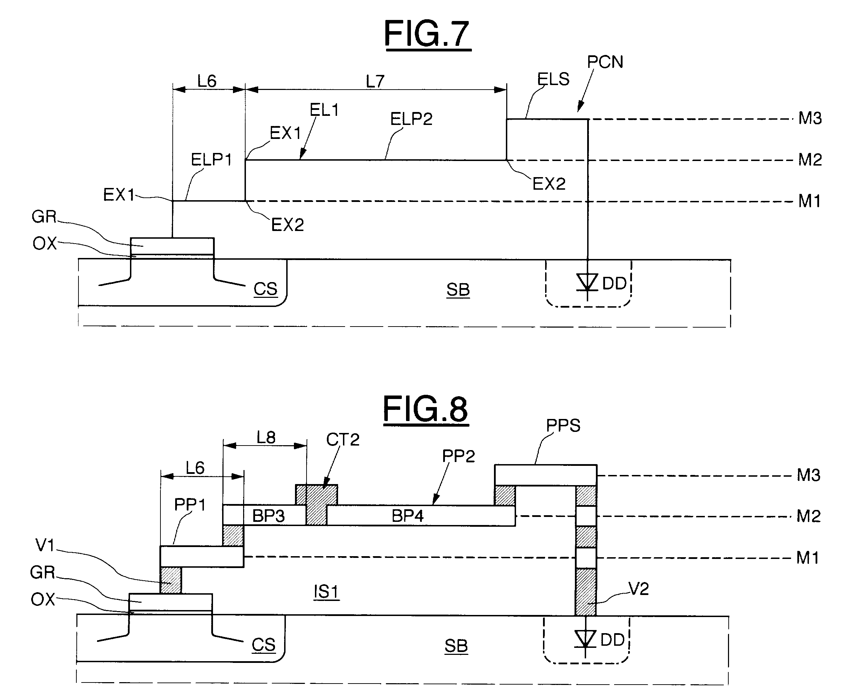

Sur la figure 7, on suppose que la configuration géométrique initiale de la piste d'interconnexion PCN prévoit trois niveaux de métallisation M1, M2 et M3, avec un premier élément de piste EL1 comportant une première partie ELP1 s'étendant au niveau M1, et une deuxième partie ELP2 s'étendant au niveau M2. On suppose également que la longueur L7 de la deuxième partie ELP2 est à elle seule supérieure à la longueur critique, la longueur L6 de la première partie ELP1 étant inférieure à la longueur critique.

Dans un tel cas, on sélectionnera, par exemple dans la deuxième partie ELP2 de l'élément de piste EL1, un emplacement compatible avec le schéma général de conception du circuit intégré et situé à une distance L8 de la première extrémité de cet élément de piste ELP2, de sorte que la longueur L8 soit inférieure à la longueur critique.

D'une façon analogue à ce qui vient d'être décrit ci-avant en référence aux figures 1 à 6, on réalisera une portion de piste PP2 interrompue au niveau de cet emplacement sélectionné, puis on court-circuitera les deux branches ainsi obtenues BP3 et BP4 par un contact métallique de remplissage CT2 (figure 8).

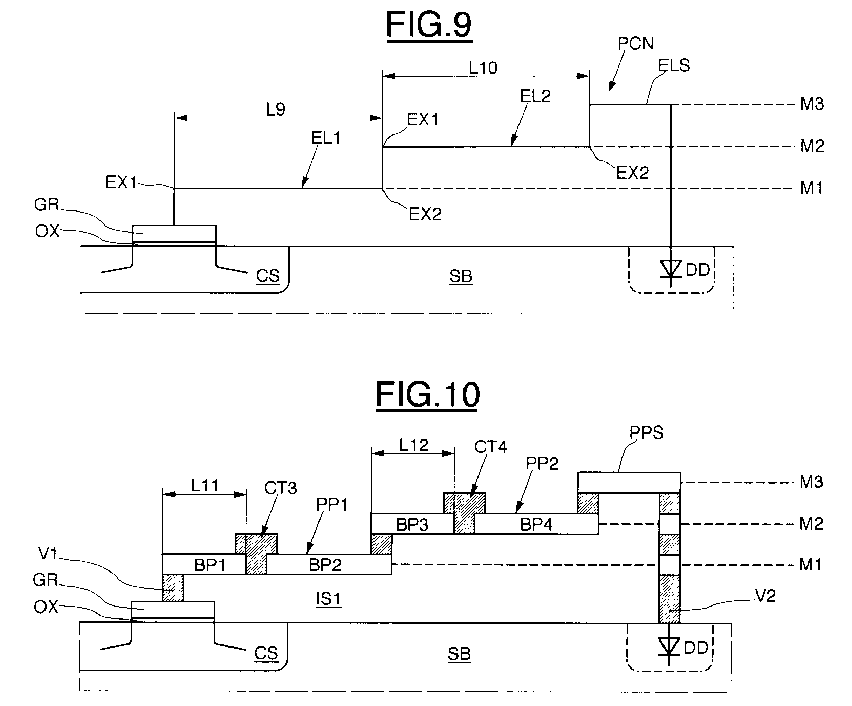

Sur la figure 9, on suppose que la piste d'interconnexion PCN s'étend encore sur trois niveaux de métallisation avec un premier élément de piste ELI situé au premier niveau de métallisation M1 et ayant une longueur L9 supérieure à la longueur critique, et un deuxième élément de piste EL2 situé au niveau de métallisation M2 et ayant une longueur L10 également supérieure à la longueur critique.

Dans ce cas, on sélectionnera sur ces deux éléments de piste deux emplacements respectivement espacés de la première extrémité de l'élément de piste correspondant d'une distance L11 et L12 (figure 10) tel que chacune des longueurs L11 et L12 soit inférieure à la longueur critique. On réalisera alors au niveau de ces emplacements deux contacts métalliques CT3 et CT4.

En d'autres termes, plus généralement, lorsqu'un premier élément de piste (par exemple EL1, figure 7) comporte plusieurs parties (ELP1, ELP2) s'étendant sur plusieurs niveaux de métallisations distincts situés sous le niveau de métallisation le plus élevé, et que la première de ces parties (ELP1) a une première extrémité (EX1) directement reliée à la grille et une deuxième extrémité (EX2) opposée à la première (EX1), chaque partie suivante (ELP2) ayant une première extrémité (EX1) reliée à la deuxième extrémité (EX2) d'une partie (ELP1) située à un niveau de métallisation inférieur, et que certaines au moins de ces parties (par exemple ELP2) comportent respectivement des contacts métalliques de remplissage (CT2) respectivement espacés de la première extrémité correspondante (EX1) d'une distance élémentaire (L8), chacune de ces distances élémentaires (L8) ainsi que la longueur de chaque partie (par exemple ELP1) exempte de contact métallique de remplissage, est inférieure à la longueur critique.

## Revendications

1. Procédé de réalisation, au sein d'un circuit intégré, d'une piste d'interconnexion métallique reliant, sur plusieurs niveaux de métallisation, une grille isolée (GR) d'un transistor à une diode de décharge (DD), comprenant la définition d'une configuration géométrique initiale de ladite piste (PCN), et la réalisation de chaque niveau de métallisation à partir de la formation d'une couche isolante de support et d'une gravure d'une couche de métal déposée sur la couche isolante de support, caractérisé par le fait que, ladite piste ainsi configurée (PCN) comportant un premier élément de piste (EL1) s'étendant sous le niveau de métallisation le plus élevé (M2), possédant une première extrémité (EX1) reliée à ladite grille et ayant une longueur (L1) supérieure à une longueur critique prédéterminée, on sélectionne au sein du premier élément de piste un emplacement (ENP) espacé de ladite première extrémité d'une première distance (L2) inférieure à ladite longueur critique, et dans l'étape de réalisation du niveau de métallisation contenant cet emplacement sélectionné, on grave dans la couche de métal à l'endroit de cet emplacement sélectionné une zone (Z1) exempte de métal de façon à réaliser une portion de piste interrompue, puis dans l'étape de réalisation du niveau de métallisation immédiatement supérieur, on ménage dans la couche isolante de support (IS2) déposée sur ladite portion de piste interrompue, une cavité (CV1) débouchant en regard de ladite zone, et on remplit ladite cavité ainsi que ladite zone par un métal de remplissage de façon à rétablir un contact métallique (CT1) entre les deux branches (BP1, BP2) de la portion de piste interrompue pour réaliser un élément de piste conforme à sa configuration géométrique initiale.

2. Procédé selon la revendication 1, caractérisé par le fait qu'on ménage, dans ladite couche isolante de support (IS2) du niveau de métallisation supérieur (M2), une cavité (CV1) ayant une taille plus importante que celle que ladite zone (Z1) de la portion de piste interrompue.

3. Procédé selon la revendication 1 ou 2, caractérisé par le fait que dans l'étape de remplissage de la cavité, on dépose sur la couche isolante de support (IS2) située sur ladite portion de piste interrompue, ainsi que dans ladite cavité et dans ladite zone, du métal de remplissage puis on effectue un polissage mécano-chimique de la couche de métal de remplissage déposée sur la couche isolante de support.

4. Procédé selon l'une des revendications précédentes, caractérisé par le fait que le premier élément de piste comportant plusieurs parties (EL1, EL2) s'étendant sur plusieurs niveaux de métallisation distincts (M1, M2) situés sous le niveau de métallisation le plus élevé (M3), on réalise sur une première partie (EL1) un premier contact métallique de remplissage (CT3) espacé de la grille de ladite première distance (L11), et on réalise sur au moins une deuxième partie (EL2) un deuxième contact métallique de remplissage (CT4) analogue au premier et espacé de l'extrémité (EX1) de cette deuxième partie (EL2) reliée à la première partie (EL1) d'une deuxième distance (L12), chacune des première et deuxième distances étant inférieure à la longueur critique.

5. Piste d'interconnexion métallique reliant sur plusieurs niveaux de métallisation, au sein d'un circuit intégré, une grille isolée d'un transistor à une diode de décharge, caractérisée par le fait qu'elle comprend un premier élément de piste (EL1) s'étendant sous le niveau de métallisation le plus élevé, possédant une première extrémité (EX1) reliée à ladite grille (GR) et ayant une longueur (L1) supérieure à une longueur critique prédéterminée, ce premier élément de piste comportant une portion de piste interrompue (PP1) en un endroit (EMP) espacé de ladite première extrémité d'une première distance (L2) inférieure à ladite longueur critique, s'étendant entre deux couches isolantes (IS1, IS2) sur un même niveau de métallisation (M1), les deux branches (BP1, BP2) de ladite portion interrompue étant mutuellement reliées par un contact métallique de remplissage (CT1) s'étendant également dans la couche isolante de support (IS2) du niveau de métallisation (M2) immédiatement supérieur à celui (M1) contenant ladite portion de piste interrompue.

6. Piste selon la revendication 5, caractérisée par le fait que la partie (CT10) du contact métallique située entre les extrémités des deux branches de la portion de piste interrompue, a un volume plus faible que celui de la partie supérieure (CT12) du contact métallique (CT1) s'étendant dans ladite couche isolante supérieure (IS2), cette partie supérieure (CT12) s'appuyant partiellement sur les deux branches (BP1, BP2) de la portion de piste interrompue (PP1).

7. Piste selon la revendication 5 ou 6, caractérisée par le fait que la résistance électrique du contact métallique (CT1) est de l'ordre d'une fraction d'ohm.

8. Piste selon l'une des revendications 5 à 7, caractérisée par le fait que le contact métallique (CT1) comporte une partie inférieure (CT13) s'étendant avec un profil bombé dans la couche isolante inférieure (IS1).

9. Piste selon l'une des revendications 5 à 7, caractérisée par le fait que le contact métallique (CT1) ne déborde pas dans la couche inférieure isolante.

10. Piste selon l'une des revendications 5 à 9, caractérisé par le fait que le premier élément de piste (EL1) comporte plusieurs parties (ELP1, ELP2) s'étendant sur plusieurs niveaux de métallisation distincts situés sous le niveau de métallisation le plus élevé, la première partie (ELP1) ayant une première extrémité (EX1) directement reliée à la grille (GR) et une deuxième extrémité (EX2) opposée à la première (EX1), et chaque partie suivante (ELP2) ayant une première extrémité (EX1) reliée à la deuxième extrémité (EX2) d'une partie située à un niveau de métallisation inférieur, par le fait que certaines au moins de ces parties (ELP2) comportent respectivement des contacts métalliques de remplissage (CT2) respectivement espacés de la première extrémité correspondante (EX1) d'une distance élémentaire (L8), et par le fait que chacune de ces distances élémentaires (L8) ainsi que la longueur (L6) de chaque partie (ELP1) exempte de contact métallique de remplissage est inférieure à la longueur critique.
